# EUROPEAN PATENT SPECIFICATION

(11) **EP 2 426 575 B1**
(45) Date of publication and mention of the grant of the patent: **05.09.2018**
(21) Application number: 11152326.2
(22) Date of filing: 27.01.2011
(51) Int. Cl.: G06F 1/20, H01L 23/467, H01L 23/427

(54) **Heat-dissipation device**
Wärmeableitungsvorrichtung
Dispositif de dissipation thermique

(30) Priority: 28.05.2010 TW 099117299
(43) Date of publication of application: 07.03.2012
(73) Proprietor: Giga-Byte Technology Co., Ltd., New Taipei City 231 (TW)
(72) Inventor: Huang, Shun-Shih, Taipei Hsien Hsin Tien 231 (TW); Mao, Tai-Chuan, Taipei Hsien 231, Hsin Tien (TW)
(74) Representative: Becker Kurig Straus

(56) References cited:
- US-A1- 2002 185 259
- US-A1- 2005 103 471
- US-A1- 2006 002 082
- US-A1- 2008 247 136
- US-B1- 6 450 251

## Description

### BACKGROUND OF THE INVENTION

### Field of the Invention

The present invention relates to a heat-dissipation device and more particularly relates to a heat-dissipation device including fans.

### Description of the Prior Art

With technology advancement, computers or their graphics cards have adopted integrated circuits with higher computing capability, such as central processing units (CPU) or graphic processing units (GPU) etc. However, when the integrated circuits are utilized to execute various operations, they will generate a large of heat. Thus, a heat-dissipation device is needed for dissipating heat from the integrated circuits.

These kinds of heat-dissipation devices usually adopt multi-fans design or altered arrangement for fins of a heat sink. For example, R.O.C. patents nos. relating to multi-fans are as follows: 585305, 587769, 200644780, 545104, 577582, 200410626, 592347 and M245506, and US patents nos. 5997266 and 7535708 etc.; and R.O.C. patents nos. 1251460 and 1220704 are disclosed about altered arrangement for fins of a heat sink.

In the R.O.C. patents nos. 592347 and M245506, the disclosed heat-dissipation devices referred to at least one fan is formed a slopy shape. Moreover, in the R.O.C. patent no. 585305, the heat-dissipation device further includes three fans.

US 2008/247136 A1 disclosed a heat dissipating apparatus for dissipating heat generated by heat producing device, includes a base, a fin set and an axial fan.

The base is secured on the heat producing device. The fin set comprises a plurality of fins arranged on the base; the fins are spaced apart from and oriented parallel to each other, and form a plurality of air passages therebetween. The axial fan is installed at a lateral side of the fin set and directs airflow into the fin set through the air passages. The fin set has an inclined area at an end thereof, and the fan is installed on the inclined area of the fin set and oblique to the base.

US 6,450,251 B1 disclosed a heat removal system includes a heat dissipation assembly (10) and a system fan (20) which cooperatively achieve optimized heat dissipation efficiency. The heat dissipation assembly includes a heat sink (12) and an angled fan (14). The heat sink includes a base (122) and a plurality of parallel fins (124). A slanted surface (126) is defined by a set of adjacent edges of the fins. The fan defines a through hole (142) at each of four corners thereof. Four screws (144) extend through the through holes, thus attaching the fan to the heat sink at the slanted surface. A rotational axis of the fan intersects a central portion of the base of the heat sink, which portion defines a region of highest temperature of the heat sink. The angled fan together with the system fan provide maximized cooling airflow.

US 2002/185259 A1 disclosed an angle-mounted fan sink for an electronic device, such as the processor of a computer system, or the like includes a heat sink coupled to a surface of the electronic device for conducting heat away from the electronic device. A fan assembly is mounted in an oblique orientation to the base of the heat sink. The fan assembly circulates a cooling medium such as air over the heat sink at an angle that is generally oblique to the surface of the electronic device for dissipating het from the heat sink.

US 2006/002082 A1 disclosed a heat sink having graduated lengths of fins, with the tallest fins being in the center of the heat sink to provide maximum heat removal from a mated integrated circuit (IC) chip. Dual fans impinge air against the fins, and particularly the tallest fins, to provide a highly efficient system for heat removal from the IC chip. By reducing the size of the lateral fins, additional space is made available for the dual fans. The use of the dual fans allows the fans to run at a lower speed that a single fan, thus reducing an overall fan acoustic level. Furthermore, the dual fans allow for a backup fan system if one of the fans should fail.

### SUMMARY OF THE INVENTION

The present invention is provided by appended claims 1, 5, and 9. Beneficial embodiments are provided by the dependent claims. The following disclosure of embodiments serves a better understanding of the invention. Accordingly, the disclosure provides a heat-dissipation device, featuring a rotating axis and a surface of a circuit board forming an acute angle. Encountering the surface of the circuit board, air flows from fans will be forced to flow toward the same direction for enhancing efficiency of cooling the heat-dissipation device.

As mentioned-above, in the heat-dissipation device of the present disclosure, the rotating axis of the fan is not vertical to the surface of the circuit board. In another word, the fan is disposed on the surface of the circuit board by a slope-type. Therefore, the air flows generated from the fan will be integrated to flow toward a single direction after encountering the surface of the circuit board for preventing interferences with those air flows causing bigger resistance of the air flows and effecting the efficiency of cooling the heat-dissipation device.

The rest of the contents of the present disclosure and the detailed description of the techniques and functions are disclosed in the following description with reference to preferred exemplified embodiments and the accompanying drawings.

### BRIEF DESCRIPTION OF THE DRAWINGS

FIG. 1A is a diagram of a heat-dissipation device of an example of the present disclosure;
FIG. 1B is a cross section diagram on yz plane of the heat-dissipation device in FIG. 1A;
FIG. 2A is a diagram of a heat-dissipation device of an example of the present disclosure;
FIG. 2B is a cross section diagram on yz plane of the heat-dissipation device in FIG. 2A;
FIG. 3A is a diagram of a heat-dissipation device of a first embodiment of the present disclosure;
FIG. 3B is an explode view of the heat-dissipation device in FIG. 3A;
FIG. 3C is a diagram of the heat sink and the heat-conducting module of the heat-dissipation device in FIG. 3A;
FIG. 3D is a cross section diagram on yz plane of the heat-dissipation device in FIG. 3A;
FIG. 3E is a cross section diagram on xz plane of the heat-dissipation device in FIG. 3A;
FIG. 3F is diagram of the heat-dissipation device of the FIG. 3A in a computer;
FIG. 4A is diagram of a heat-dissipation device of a second embodiment of the present disclosure;
FIG. 4B is a cross section diagram on xy plane of the heat-dissipation device in FIG. 4A;
FIG. 4C is a cross section diagram on yz plane of the heat-dissipation device in FIG. 4A;
FIG. 4D is a cross section diagram on xz plane of the heat-dissipation device in FIG. 4A;
FIG. 5A is a diagram of a heat-dissipation device of a third embodiment of the present disclosure;
FIG. 5B is a cross section diagram on xy plane of the heat-dissipation device in FIG. 5A;
FIG. 5C is a cross section diagram on yz plane of the heat-dissipation device in FIG. 5A;
FIG. 5D is a cross section diagram on xz plane of the heat-dissipation device in FIG. 5A;
FIG. 6A is a diagram of a heat-dissipation device of an example of the present disclosure;
FIG. 6B is a cross section diagram on xy plane of the heat-dissipation device in FIG. 6A;
FIG. 6C is a cross section diagram on xz plane of the heat-dissipation device in FIG. 6A;
FIG. 7A is a diagram of a heat-dissipation device of an example of the present disclosure;
FIG. 7B is a cross section diagram on xy plane of the heat-dissipation device in FIG. 7A;
FIG. 7C is a cross section diagram on yz plane of the heat-dissipation device in FIG. 7A; and
FIG. 8 is a cross section diagram on yz plane of the heat-dissipation device in an example of the present disclosure.

### DETAILED DESCRIPTION OF THE INVENTION

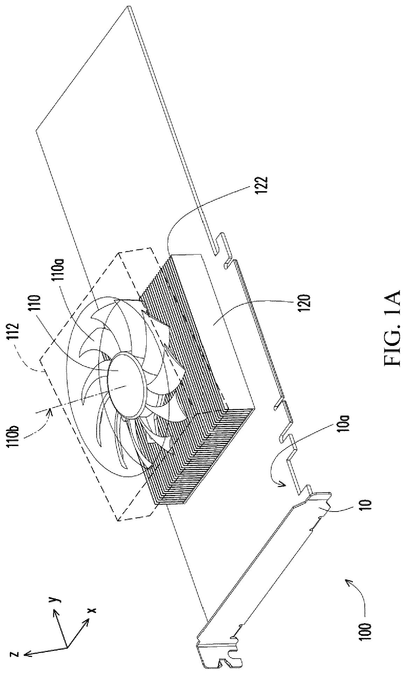

FIG. 1A is a diagram of a heat-dissipation device of an example of the present disclosure. Please refer to FIG. 1A, in this example, a heat-dissipation device 100 is utilized to dissipate heat from a circuit board 10. The circuit board 10, for example, is a graphics card, a memory module, a sound card, or the other circuit board. The circuit board 10 has a surface 10a. The heat-dissipation device 100 comprises a first fan 110 and a heat sink 120. Blades 110a of the first fan 110 rotate around a first rotating axis 110b, and the first rotating axis 110b and the surface 10a of the circuit board 10 are forming an acute angle θ. The first fan 110 further has a fan housing 112 for fixing the first fan 110 and guiding air flows of the first fan 110 to the heat sink 120. In order to clear the view diagram, the fan housing 112 is draw by dotted line. The heat sink 120 is disposed between the surface 10a of the circuit board 10 and the first fan 110.

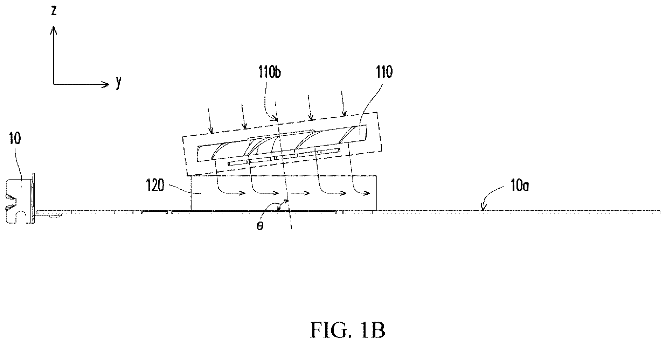

FIG. 1B is a cross section diagram on yz plane of the heat-dissipation device in FIG. 1A. Please refer to FIGs. 1A and 1B, in this example, the first rotating axis 110b of the first fan 110 and the surface 10a of the circuit board 10 are forming an acute angle θ. In another word, the first rotating axis 110b is not parallel to the normal direction of the surface 10a, and the first fan 110 is assembled by a slope-type. When the first rotating axis 110b of the first fan 110 and the surface 10a of the circuit board 10 are forming an acute angle θ, the air flows of the first fan 110 (the air flows are draw by arrows in FIG. 1B) will be integrated to flow toward the same direction (as the air flows toward y axis shown in FIG. 1B) after encountering the surface 10a of the circuit board 10. Thus, it will prevent that the air flows of the first fan 110 behaving as undirected dissipation after encountering the surface 10a of the circuit board 10 then causing the interference of these air flow and reducing the efficiency of cooling the heat-dissipation device 100. Otherwise, because the first fan 110 of the present example is assembled by a slope-type, the quiescent zone of air flows below the rotating axis of the first fan 110 would be destroyed by the air flow of the first fan 110 for enhancing the efficiency of cooling the heat-dissipation device 100. Please refer to FIG. 1A again, the heat sink 120 of the present example is direct to or with a heat transfer paste to attach on the surface 10a of the circuit board 10, thus, the heat generated from the circuit board 10 would be dissipated by conduction. Moreover, the heat sink 120 includes a plurality of fins 122 that parallel in arrangement. These fins 122 are disposed vertically on the surface 10a of the circuit board 10, and these fins 122 are parallel to the first rotating axis 110b of the first fan 110. Therefore, the air flows of the first fan 110 are passed through the passageways formed from those fins 122 smoothly. Thus, the efficiency of the air flows of the fan will be reached to the best, and the heat generated from the circuit board 10 will be dissipated quickly by convection.

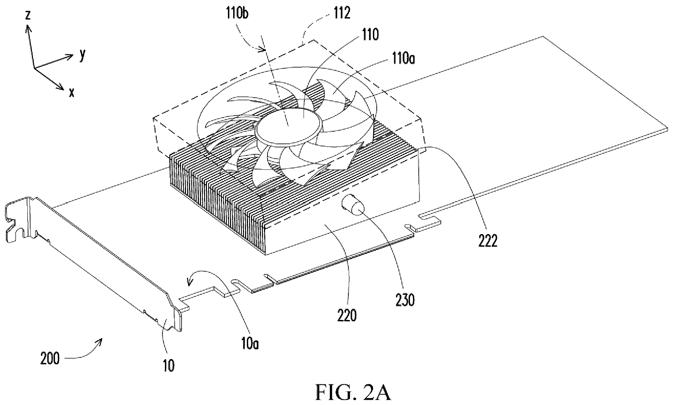

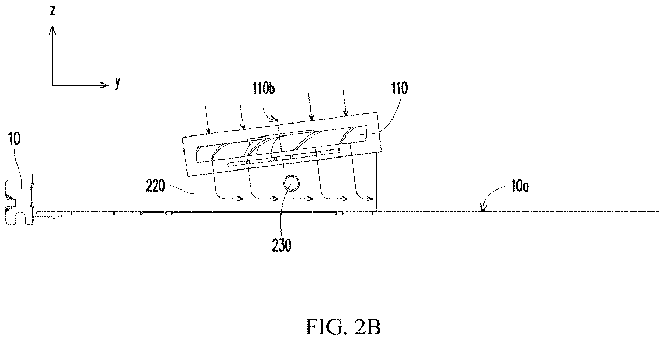

FIG. 2A is a diagram of a heat-dissipation device of an example of the present disclosure. FIG. 2B is a cross section diagram on yz plane of the heat-dissipation device in FIG. 2A. Please refer to FIGs. 2A and 2B, in this example, the heat-dissipation device 200 is similar to the heat-dissipation device 100 in FIGs 1A and 1B. Thus, only the differences are introduced here. The laterals of the fins 222 of the heat-dissipation device 220 of the present example are formed into trapezium. Otherwise, the fins 222 close to the edge of the first fan 110 are substantially vertical to the first rotating axis 110b of the first fan 110. Therefore, the first fan 110 of the present example is assembled by a slope-type, and an inclined plane is provided to assemble the first fan 110. Moreover, the edges of the fins 222 are vertical to the first rotating axis 110b of the first fan 110. When the air flows of the first fan 110 is flowed toward the fins 222, the air flows will more close to the fins 222, in other word, the flowing distance between the air flows and fins 222 is shorter. Thus, the spent time of removing heat generated from the circuit board 10 would be shorter. In addition, the heat-dissipation device 200 of the present example further comprises at least a heat pipe 230, and the heat pipe 230 are passed through and connected with the fins 222. The heat pipe 230 would be speed up the dissipation of the heat generated from the circuit board 10 to the outside world. Therefore, the heat pipe 230 disposed on the heat-dissipation device 200 of the present example will enhance the cooling efficiency.

### [First Embodiment]

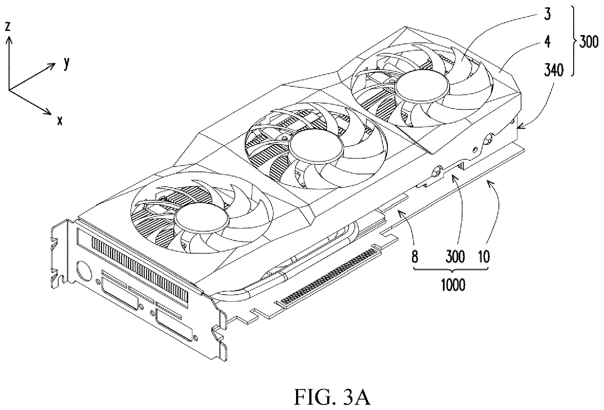

FIGs. 3A to 3F show diagrams of the heat-dissipation device of the first embodiment according to the present invention. FIG. 3A is a diagram of a heat-dissipation device of the first embodiment of the present invention. Please refer to FIG. 3A, a heat-dissipation system 1000 of the present embodiment comprises a heat-dissipation device 300, a circuit board 10 and a heat-conducting module 8. The heat-dissipation device 300 is utilized to dissipate heat from the circuit board 10, and the heat-dissipation device 300 comprises a heat sink 340, a set of fans 3 and a fan housing 4.

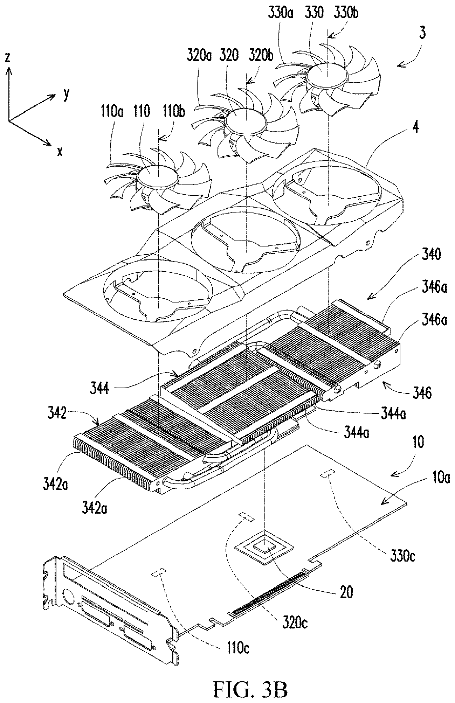

FIG. 3B is an explode view of the heat-dissipation device in FIG. 3A. Please refer to FIG. 3B, the circuit board 10 of the present embodiment is, such as, a graphics card. The circuit board 10 has a heat source 20. The heat source 20 means a GPU on the graphics card. Besides the GPU, the circuit board 10 further has the other associated circuits and electric units.

The heat sink 340 is utilized to absorb the heat generated from the heat source 20 of the circuit board 10, and the heat sink 340 includes a first heat-dissipation module 342, a second heat-dissipation module 344 and a third heat-dissipation module 346, which are parallel in arrangement and adjacent along the y-axis direction.

The set of fans 3 comprises a first fan 110, a second fan 320 and a third fan 330. The first fan 110, the second fan 320 and the third fan 330 are disposed separately on the fan housing 4. The fan housing 4 is utilized to cover the heat sink 340. In addition, in the present embodiment, the blades 110a of the first fan 110 rotate around a first rotating axis 110b, the blades 320a of the second fan 320 rotate around a second rotating axis 320b, and the blades 330a of the third fan 330 rotate around a third rotating axis 330b. In this embodiment, the first rotating axis 110b, the second rotating axis 320b and the third rotating axis 330b and the surface 10a of the circuit board 10 are forming an acute angle. In another word, the first rotating axis 110b, the second rotating axis 320b and the third rotating axis 330b are not parallel to the normal direction of the surface 10a, and the fans are disposed on the surface 10a of the circuit board 10 by a slope-type.

As mentioned-above, the heat sink 340 is disposed between the surface 10a of the circuit board 10 and the first fan 110, the second fan 320 and the third fan 330. The second fan 320 is disposed between the first fan 110 and the third fan 330. Otherwise, the orthogonal projection 320c of the second rotating axis 320b and the orthogonal projection 110c of the first rotating axis 110b on the surface 10a of the circuit board 10 are perpendicular to one another, and the orthogonal projection 320c of the second rotating axis 320b and the orthogonal projection 330c of the third rotating axis 330b are perpendicular to one another. Furthermore, the end of the first rotating axis 110b close to the circuit board 10 and heading the direction away from the second fan 320, and the end of the third rotating axis 330b close to the circuit board 10 and heading the direction away from the second fan 320. When air flows of these three fans are flowed, the air flows of the first fan 110 and the third fan 330 are flowed from the second fan 320, and the air flows of the second fan 320 are flowed from the first fan 110 and the third fan 330. In this embodiment, the directions of those air flows are different and do not cause interference with each other. Thus, the resistance of the air flows is reduced and the air flows of each fan could be used efficiently and the efficiency of cooling the heat-dissipation device 300 are enhanced.

In this embodiment, the heat sink 340 includes a plurality of first fins 342a that parallel in arrangement, a plurality of second fins 344a that parallel in arrangement and a plurality of third fins 346a that parallel in arrangement. The first fins 342a are disposed between the surface 10a of the circuit board 10 and the first fan 110, the second fins 344a are disposed between the surface 10a of the circuit board 10 and the second fan 320, and the third fins 346a are disposed between the surface 10a of the circuit board 10 and the third fan 330. The first fins 342a, the second fins 344a and the third fins 346a are disposed vertically on the surface 10a of the circuit board 10. The first fins 342a are parallel to the first rotating axis 110b, the second fins 344a are parallel to the second rotating axis 320b, and the third fins 346a are parallel to the third rotating axis 330b. In other words, when the orthogonal projection of the rotating fan on the surface 10a of the circuit board 10 is parallel to the fins, the direction of the rotating axis and the direction of the fins have the same direction. Thus, the air flows will be flowed along the direction of the fins, and heat generated from the circuit board 10 will be dissipated more quickly. The air flows of the first fan 110, the second fan 320 and the third fan 330 will be passed through the passageways formed from the first fins 342a, the second fins 344a and the third fins 346a smoothly, and the air flows of the fans will be reached the best efficiency.

Besides, in the present embodiment, in order to let the first fan 110, the second fan 320 and the third fan 330 dispose in slope-type, the laterals of the first fins 342a, the second fins 344a and the third fins 346a are formed in the shape of trapezium for providing an inclined plane to dispose those fans. The first fins 342a close to the edge of the first fan 110 are substantially vertical to the first rotating axis 110b, the second fins 344a close to the edge of the second fan 320 are substantially vertical to the second rotating axis 320b, and the third fins 346a close to the edge of the third fan 330 are substantially vertical to the rotating axis 330b. When the air flows of the first fan 110, the second fan 320 and the third fan 330 are flowed toward the first fins 342a, the second fins 344a and the third fins 346a, respectively, the air flows are more close to the fins and the flowing distance of the air flows are shorter. Thus, the spent time of the dissipation of heat generated from the circuit board 10 is also shorter.

The fan housing 4 is mainly utilized to fix the first fan 110, the second fan 320 and the third fan 330. In practical application, the first fan 110, the second fan 320 and the third fan 330 are also fixed by suspending with brackets, or, the first fan 110, the second fan 320 and the third fan 330 are fixed on the top of the heat sink 340 by other way.

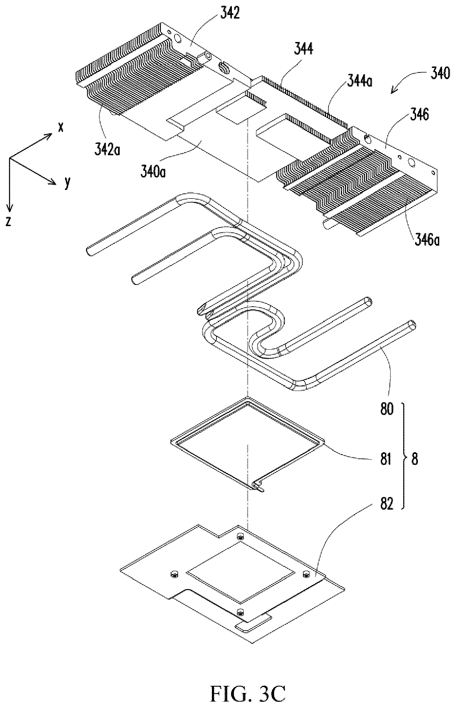

FIG. 3C is a diagram of the heat sink and the heat-conducting module of the heat-dissipation device in FIG. 3A. Please refer to FIG. 3C, in this embodiment, the bottom of the heat sink 340 has a contact surface 340a to the heat source 20. The heat-conducting module 8 is disposed between the heat-dissipation device 300 and the heat source 20 of the circuit board 10, and utilized to guide heat generated from the heat source 20 on the circuit board 10 into the heat sink 340. The heat-conducting module 8 comprises a plurality of heat pipe 80, a heat-conducting plate 81 (such as a copper base plate) and a fixing plate 82. In this embodiment, the number of the heat pipe 80 could be only one, but it's not utilized to limit in the scope of the present invention. A person skilled in the art could depend on his needs to amend the numbers of the heat pipe 80. One end of the heat pipe 80 is passed through and connected the first fins 342a, the second fins 344a and the third fins 346a, respectively. The heat-conducting plate 81 is connected to another end of the heat pipe 80, and disposed between the heat source 20 and the contact surface 340a on the heat sink 340. Thus, the heat-conducting plate 81 could directly guide heat from the heat source 20 to the first heat-dissipation module 342, the second heat-dissipation module 344 and the third heat-dissipation module 346; alternatively, the heat pipe 80 could indirectly disperse the heat to the first heat-dissipation module 342, the second heat-dissipation module 344 and the third heat-dissipation module 346. The fixing plate 82 is utilized to fix the heat pipe 80 and heat-conducting plate 81 on the heat sink 340.

In this embodiment, the contact surface 340a of the heat sink 340 is attached on the heat-conducting plate 81, and the heat generated from the heat source 20 would be guided to the heat sink 340 by the heat-conducting plate 81. In practice, the contact surface 340a of the heat sink 340 is also attached on the heat source 20 directly.

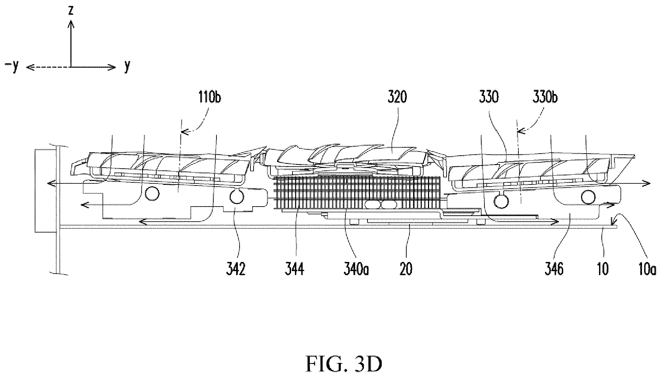

FIG. 3D is a cross section diagram on yz plane of the heat-dissipation device in FIG. 3A. Please refer to FIG. 3D, in this embodiment, the first rotating axis 110b of the first fan 110 is not vertical to the surface 10a of the circuit board 10. Thus, the first fan 110 and the contact surface 340a of the heat sink 340 are inclined, and the slope direction is adjacent to one end of the second fan 320 to the first heat-dissipation module 342. The third rotating axis 330b of the third fan 330 is not vertical to the surface 10a of the circuit board 10. Thus, the third fan 330 and the contact surface 340a of the heat sink 340 are also inclined, and the slope direction is adjacent to one end of the second 320 to the third heat-dissipation module 346. The air flows of the first fan 110 will be flowed toward the -y-axis direction after encountering the surface 10a of the circuit board 10, and the air flows of the third fan 330 will be flowed toward the y-axis direction after encountering the surface 10a of the circuit board 10. Therefore, the directions of the two air flows are opposite and do not interference each other because the -y-axis is the opposite direction of the y-axis. Otherwise, the ends of the first fan 110 and the third fan 330 adjacent to the second fan 320 are lower, thus, the air flows of the first fan 110 and third fan 330 will pass through the first heat-dissipation module 342 and the third heat-dissipation module 346 quickly, respectively.

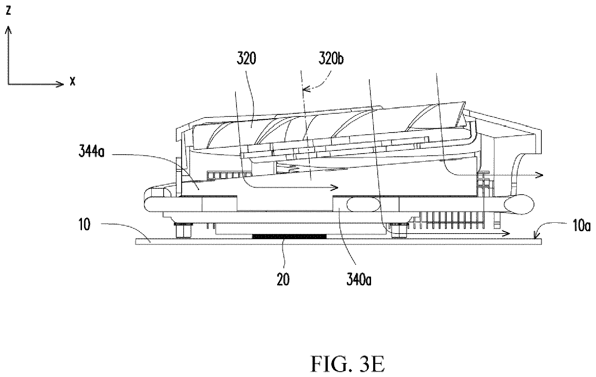

FIG. 3E is a cross section diagram on xz plane of the heat-dissipation device in FIG. 3A. Please refer to FIG. 3E, in this embodiment, the rotating axis 320b of the second fan 320 is not vertical to the surface 10a of the circuit board 10, thus, the second fan 320 and the contact surface 340a of the heat sink 340 are inclined, and the slope direction is along x-axis direction. The air flows of the second fan 320 will be flowed toward the x-axis direction after encountering the surface 10a of the circuit board 10. Thus, the air flows generated from the second fan 320 will be passed through the second heat-dissipation module 344 quickly, and the air flows of the first fan 110, the second fan 320 and the third fan 330 do not interference each other. The air flows of each fan will be flowed toward a single direction for enhancing the efficiency of cooling the heat-dissipation device 300.

Because the first fan 110, the second fan 320 and the third fan 330 are disposed by a slope-type, the air flows of the first fan 110, the second fan 320 and the third fan 330 (as the directions of the arrows shown) will be flowed toward the first heat-dissipation module 342, the second heat-dissipation module 344 and the third heat-dissipation module 346. These air flows will be affected by a closed area of the bottom of the air-passageways (such as a heat-conducting plate or the circuit board 10) then flowed toward the first heat-dissipation module 342, the heat-dissipation module 344 and the third heat-dissipation module 346. The quiescent zone of air flows below the rotating axis of the first fan 110, the second fan 320 and the third fan 330 is destroyed for enhancing the efficiency of cooling the first heat-dissipation module 342, the second heat-dissipation module 344 and the third heat-dissipation module 346.

Furthermore, the air flows generated from the first fan 110, the second fan 320 and the third fan 330 are flowed toward the first heat-dissipation module 342, the second heat-dissipation module 344 and the third heat-dissipation module 346, respectively. Therefore, the air flows generated from the first fan 110, the second fan 320 and the third fan 330 do not interference each other, and the efficiency of cooling the heat-dissipation device 300 is enhanced.

The laterals of first fins 342a in the first heat-dissipation module 342, the laterals of the second fins 344a in the second heat-dissipation module 344 and the laterals of the third fins 346a in the third heat-dissipation module 346 are formed in the shape of trapezium for providing the inclined planes required for the first fan 110, the second fan 320 and the third fan 330. The first fins 342a, the second fins 344a and the third fins 346a are usually made from copper or aluminum by stamping tool, alternatively, the heat sink 340 is made by aluminum extruded type.

The heat-dissipation device 300 of the present invention includes the first heat-dissipation module 342, the second heat-dissipation module 344 and the third heat-dissipation module 346, which are corresponding to the first fan 110, the second fan 320 and the third fan 330, respectively. Thus, the air flows of the first fan 110, the second fan 320 and the third fan 330 will be flowed toward one direction from the independently air-flow passageway for enhancing the cooling efficiency and reducing the noise generated from the interferences of the air flows. Otherwise, numbers of the first heat-dissipation module 342, the second heat-dissipation module 344 and the third heat-dissipation module 346, and the first fan 110, the second fan 320 and the third fan 330 can be increased or decreased arbitrarily depending on the practical application, such as, a design is only utilized the first fan 110, the second fan 320, the first heat-dissipation module 342 and the second heat-dissipation module 344 to practice, or, an embodiment is added a forth fan and a forth heat-dissipation module. The scope of the present invention is not limited in this kind of embodiments used only three fans and three heat-dissipation modules.

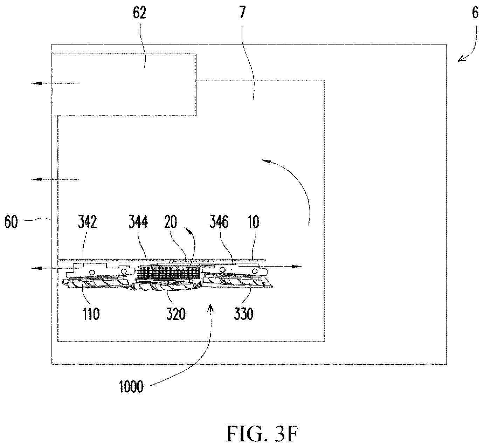

FIG. 3F is diagram of the heat-dissipation device of the FIG. 3A in a computer. Please refer to FIG. 3F, the computer 6 comprises a power supply 62, a main board 7 and a backboard 60. The air flows (as the directions of the arrows shown) generated from the sets of fans 3 after switching on are flowed toward the heat sink 340. The air flows toward the first heat-dissipation module 342 generated by the first fan 110 will pass through the air-flow passageway directly and be flowed outward from the through holes of the backboard 60. The air flows toward the second heat-dissipation module 344 generated by the second fan 320 will be flowed outward from the vent of a side of the computer 6 (not shown in figure). The air flows toward the third heat-dissipation module 346 generated by the third fan 330 are flowed toward the interior of the computer 6 directly, and with the system air flows of the interior of the computer 6 flowed outward the backboard 60.

### [Second Embodiment]

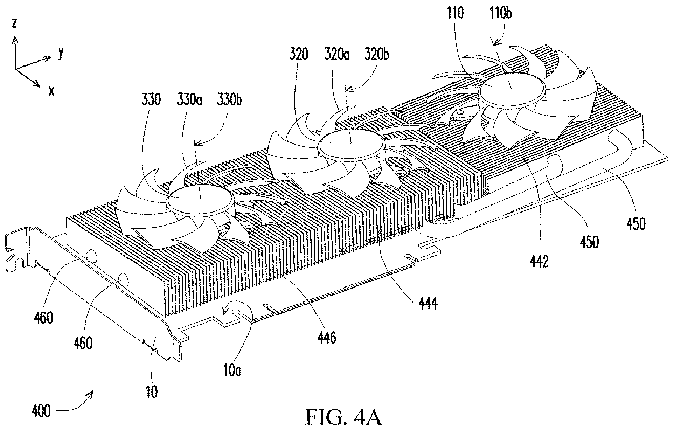

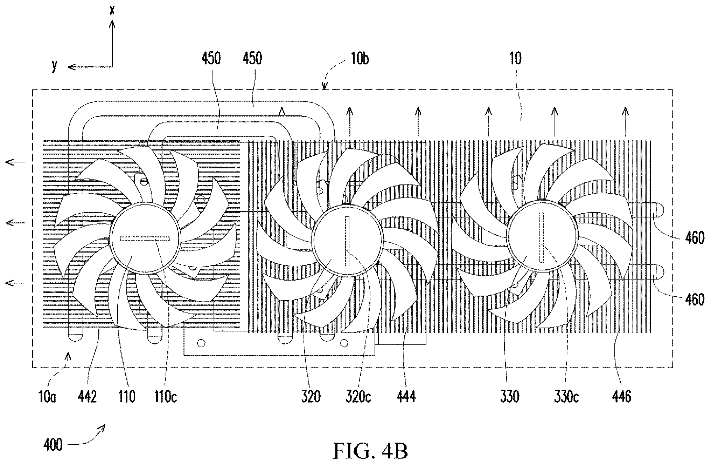

FIG. 4A is diagram of a heat-dissipation device of the second embodiment of the present invention. FIG. 4B is a cross section diagram on xy plane of the heat-dissipation device in FIG. 4A. Please refer to FIGs. 4A and 4B, in this embodiment, the heat-dissipation device 400 is similar to the heat-dissipation device 300 in the first embodiment, the same or similar units are used the same or similar reference signs to respect. The heat-dissipation device 400 of the present embodiment further comprises a second fan 320 and a third fan 330. The blades 320a of the second fan 320 rotate around a second rotating axis 320b, and the blades 330a of the third fan 330 rotate around a third rotating axis 330b. In this embodiment, the first rotating axis 110b, the second rotating axis 320b and the third rotating axis 330b and the surface 10a of the circuit board 10 are forming an acute angle. In another word, the first rotating axis 110b, the second rotating axis 320b and the third rotating axis 330b are not parallel to the normal direction of the surface 10a, and these fans are disposed on the surface 10a of the circuit board 10 by a slope-type.

As mentioned-above, the heat sink 440 is disposed between the surface 10a of the circuit board 10 and the first fan 110, the second fan 320 and the third fan 330. Otherwise, the orthogonal projection 320c of the second rotating axis 320b and the orthogonal projection 110c of the first rotating axis 110b on the surface 10a of the circuit board 10 are perpendicular to one another, and the orthogonal projection 320c of the second rotating axis 320b and the orthogonal projection 330c of the third rotating axis 330b on the surface 10a of the circuit board 10 are parallel one another or collinear. In addition, the circuit board 10 of the present embodiment includes a long side 10b. The end of the first rotating axis 110b close to the circuit board 10 and heading the direction away from the second fan 320, and the orthogonal projection 110c of the first rotating axis 110b on the surface 10a of the circuit board 10 is parallel to the long side 10b of the circuit board 10. In another word, the air flows of the three fans are flowed, and the air flows of the second fan 320 and the third fan 330 are flowed away the second fan 320. Therefore, the flowing directions of the air flows generated from the fans of the present embodiment are different, and they are not interference each other. The resistances of the air flows are reduced, and the air flows of each fan are more efficient and the efficiency of cooling the heat-dissipation device 400 is enhanced. In this embodiment, the heat sink 440 includes a plurality of first fins 442 that parallel in arrangement, a plurality of the second fins 444 that parallel in arrangement and a plurality of third fins 446 that parallel in arrangement. The first fins 442 are disposed between the surface 10a of the circuit board 10 and the first fan 110, the second fins 444 are disposed between the surface 10a of the circuit board 10 and the second fan 320, and the third fins 446 are disposed between the surface 10a of the circuit board 10 and the third fan 330. The first fins 442, the second fins 444 and the third fins 446 are disposed vertically to the surface 10a of the circuit board 10.

As mentioned-above, the first fins 442 are parallel to the first rotating axis 110b, the second fins 444 are parallel to the second rotating axis 320b, and the third fins 446 are parallel to the third rotating axis 330b. In another word, when the orthogonal projections of the rotating axes of the fans on the surface 10a of the circuit board 10 are parallel to the fins, the directions of the rotating axes and the direction of the fans are the same and the air flows are flowed along the direction of the fans (as shown in FIG. 4B). In this embodiment, the first fins 442 are disposed along the y-axis direction, and the air flows of the first fan 110 are flowed along the y-axis direction. The second fins 444 and the third fins 446 are disposed along the x-axis direction, and the air flows of the second fans 320 and the third fans 330 are flowed along x-axis direction.

Otherwise, the air flows of the first fan 110, the second fan 320 and the third fan 330 will pass through the passageways formed by the first fins 442, the second fins 444 and the third fins 446 smoothly. Thus, the heat generated from the circuit board 10 will be dissipated quickly. In this embodiment, the second fins 444 and the third fins 446 both are parallel in arrangement and along x-axis direction. In another embodiment which isn't shown, the second fins 444 and the third fins 446 are also integrated to be one piece. However, the scope of the present invention do not limit in those embodiments. A person skilled in the art will let these fins adjacent and arranged in the same direction to be one piece for reducing the cost of the heat sink 440.

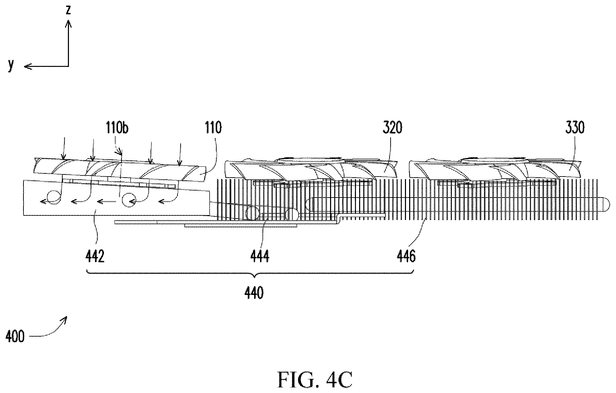

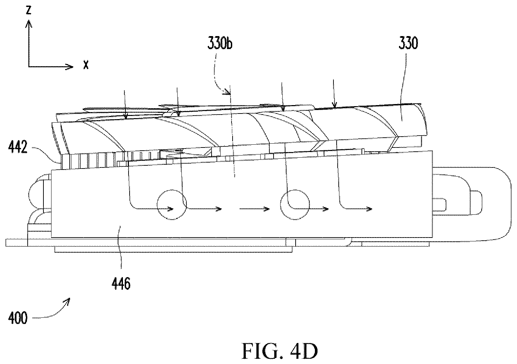

FIG. 4C is a cross section diagram on yz plane of the heat-dissipation device in FIG. 4A. FIG. 4D is a cross section diagram on xz plane of the heat-dissipation device in FIG. 4A. Please refer to FIGs. 4C and 4D, in this embodiment, in order to disposing the first fan 110, the second fan 320 and the third fan 330 by a slope-type, the laterals of the first fins 442, the second fins 444 and the third fins 446 are formed in the shape of trapezium for providing an inclined plane to disposed those fans. The first fins 442 close to the edge of the first fan 110 are substantially vertical to the first rotating axis 110b, the second fins 444 close to the edge of the second fan 320 are substantially vertical to the second rotating axis 320b, and the third fins 446 close to the edge of the third fan 330 are substantially vertical to the third rotating axis 330b. Therefore, the air flows of the first fan 110, the second fan 320 and the third fan 330 are reflowed toward the first fins 442, the second fins 444 and the third fins 446, respectively. The distance of the air flows to the fins becomes shorter, and the heat-dissipating speed of the circuit board 10 will be shorter.

Please refer to FIGs. 4A and 4B again, the heat-dissipation device 400 of the present embodiment further comprises two first heat pipes 450 and two second heat pipes 460. Alternatively, only one first heat pipe 450 and only one second heat pipe 460 are used in this embodiment. A person skilled in the art could amend the numbers of the heat pipe depending on his practice application. The first heat pipes 450 are connected with the first fins 442, and the second heat pipes 460 are passed through and connected with the second fins 444 and the third fins 446. The first heat pipe 450 and the second heat pipe 460 are transferred the heat generated from the circuit board 10 to outside world. Thus, the first heat pipe 450 and the second heat pipe 460 assembled on the heat-dissipation device 400 of the present embodiment will enhance the cooling efficiency.

### [Third Embodiment]

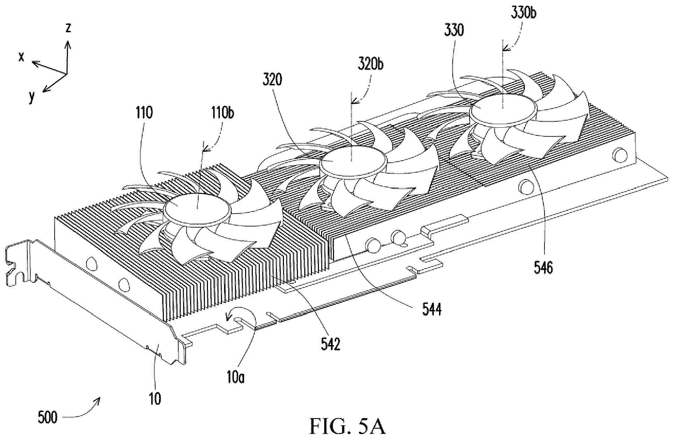

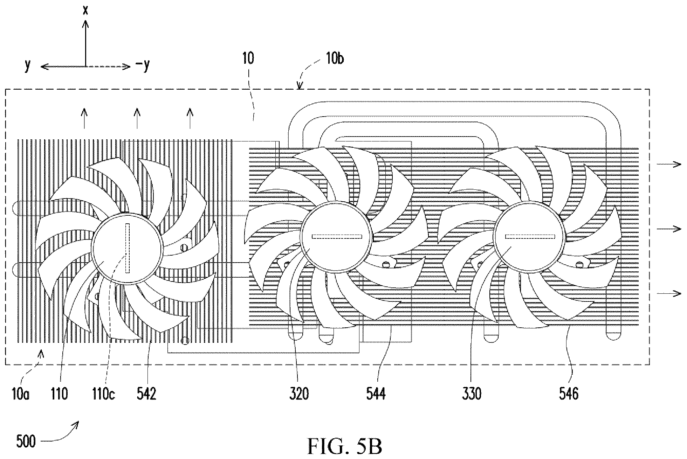

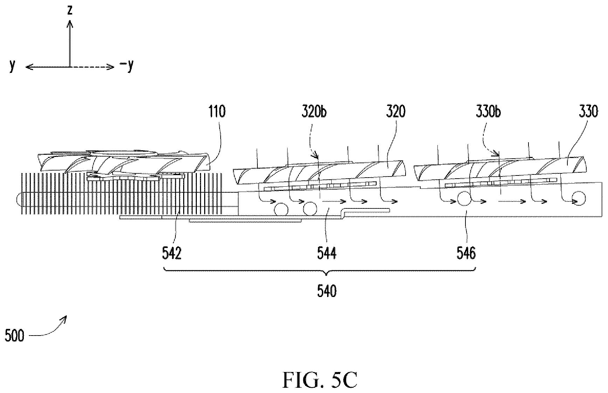

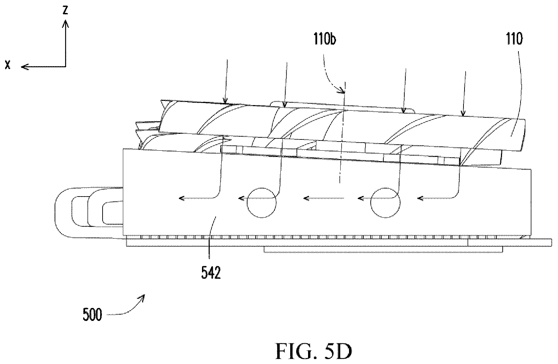

FIG. 5A is a diagram of a heat-dissipation device of the third embodiment of the present invention. FIG. 5B is a cross section diagram on xy plane of the heat-dissipation device in FIG. 5A. FIG. 5C is a cross section diagram on yz plane of the heat-dissipation device in FIG. 5A. FIG. 5D is a cross section diagram on xz plane of the heat-dissipation device in FIG. 5A. Please refer to FIGs. 5A, 5B, 5C and 5D at the same time, in this embodiment, the heat-dissipation device 500 is similar to the heat-dissipation device 400 of the second embodiment. Thus, only the differences are introduced here, and the same or similar units are used the same or similar reference signs to respect. In this embodiment, the end of the second rotating axis 320b close to the circuit board 10 and heading the direction away from the first fan 110, and the end of the third rotating axis 330b close to the circuit board 10 and heading the direction away from the first fan 110. The orthogonal projection 110c of the first rotating axis 110b on the surface 10a of the circuit board 10 is vertical to the long side 10b of the circuit board 10 (as shown in FIG. 5B). In another word, the air flows of the first fan 110 of the present embodiment will be flowed along the x-axis direction (as shown in FIG. 5D), and the direction of the first fins 542 is along the x-axis direction (as shown in FIG. 5B). The direction of the air flows of the second fan 320 and the third fan 330 are toward the -y-axis direction (as shown in FIG. 5C), and the directions of the second fins 554 and the third fins 556 are along the -y-axis direction. The -y-axis direction is the oppose direction of the y-axis direction. Thus, in this embodiment, the second fins 544 and the third fins 546 could be integrated to be a fin for reducing the cost of the heat sink 540.

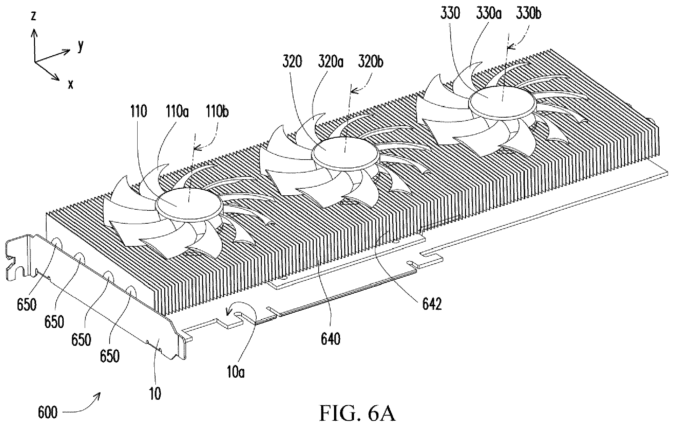

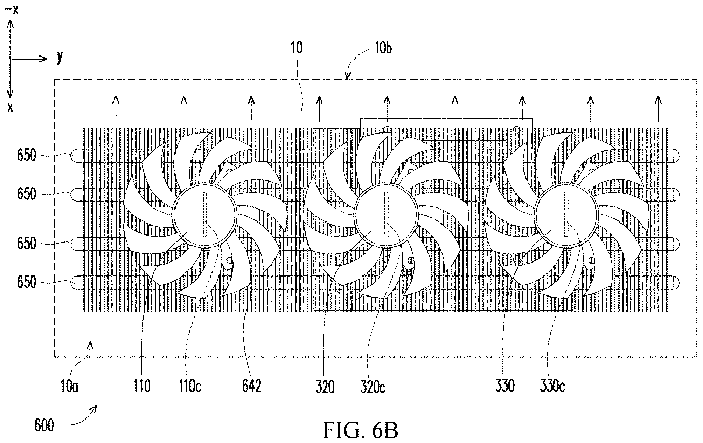

FIG. 6A is a diagram of a heat-dissipation device of an example of the present disclosure. FIG. 6B is a cross section diagram on xy plane of the heat-dissipation device in FIG. 6A. Please refer to FIGs. 6A and 6B, in this example, the heat-dissipation device 600 is similar to the heat-dissipation device 300 of the first embodiment, and the same or similar units are used the same or similar reference signs to respect. The heat-dissipation device 600 of the present example further comprises a second fan 320 and the third fan 330. The blades 320a of the second fan 320 rotate around a second rotating axis 320b, and the blades 330a of the third fan 330 rotate around a third rotating axis 330b. In this example, the first rotating axis 110b, the second rotating axis 320b and the third rotating axis 330b and the surface 10a of the circuit board 10 are forming an acute angle. In another word, the first rotating axis 110b, the second rotating axis 320b and the third rotating axis 330b are not parallel to the normal direction of the surface 10a, and these fans are disposed on the surface 10a of the circuit board 10 by a slope-type.

As mentioned-above, the heat sink 640 is disposed between the surface 10a of the circuit board 10 and the first fan 10, the second fan 320 and the third fan 330. Otherwise, the circuit board 10 of the present example includes a long side 10b. The orthogonal projections 110c, 320c, 330c of the first rotating axis 110b, the second rotating axis 320c and the third rotating axis 330c on the surface 10a of the circuit board 10, respectively, are parallel one another or collinear. The orthogonal projection 110c of the first rotating axis 110b on the surface 10a of the circuit board 10 is vertical to the long side 10b of the circuit board 10. In another word, the air flows of the first fan 110, the second fan 320 and the third fan 330 in the present example are all flowed toward the -x-axis direction (the direction of the air flows is respected as the arrows in FIG. 6B). The -x-axis direction is the oppose direction of the x-axis direction. Thus, the air flows of the three fans are flowed, and they are flowed toward the same direction. The air flows of each fan would be more efficient, and the efficiency of cooling the heat-dissipation device 600 is enhanced.

In this example, the heat sink 640 includes a plurality of fins 642 that parallel in arrangement. The fins 642 are disposed vertically on the surface 10a of the circuit board 10, and the fins 642 are parallel to the first rotating axis 110b, the second rotating axis 320b and the third rotating axis 330b. Therefore, the air flows of the first fan 110, the second fan 320 and the third fan 330 are passed through the passageways formed from the fins 642 smoothly for reaching the best efficiency of the air flows of the fans.

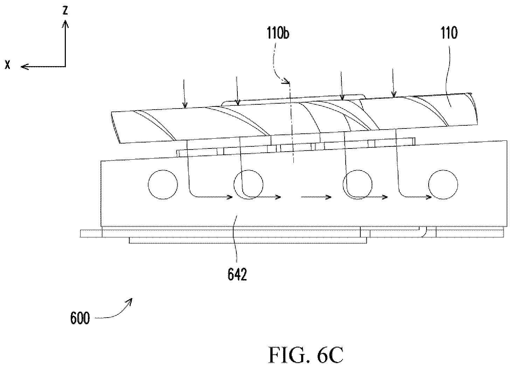

FIG. 6C is a cross section diagram on xz plane of the heat-dissipation device in FIG. 6A. Please refer to FIG. 6C, in this example, because the first fan 110, the second fan 320 and the third fan 330 are disposed by a slope-type, the laterals of the fins 642 are formed in the shape of trapezium for providing the needed inclined plane to assemble the fans. The fins 642 close to the edges of the first fan 110, the second fan 320 and third fan 330 are substantially vertical to the first rotating axis 110b, the second rotating axis 320b and the third rotating axis 330b. Thus, the air flows of the first fan 110, the second fan 320 and the third fan 330 are flowed toward the fins 642, and the flowing distance of the air flows is shorter. The dissipating speed of the heat from the circuit board 10 also becomes quickly. (However, the second fan 320, the third fan 330, the second rotating axis 320b and the third rotating axis 330 are not shown in the figure because the angle of view, it's only described in the description).

Please refer to FIGs. 6A and 6B once, the heat-dissipation device 600 of the present example further comprises four heat pipes 650. However, only one heat pipe 650 used in the present example is also accepted. A person skilled in the art could amend the numbers of the heat pipe depending on his requirement of the practical application. The heat pipes 650 are passed through and connected with those fins 642. The heat generated from the circuit board 10 is transferred to outside world by the heat pipes 650. Thus, the heat pipes 650 assembled in the heat-dissipation device 600 of the present example could enhance the cooling efficiency.

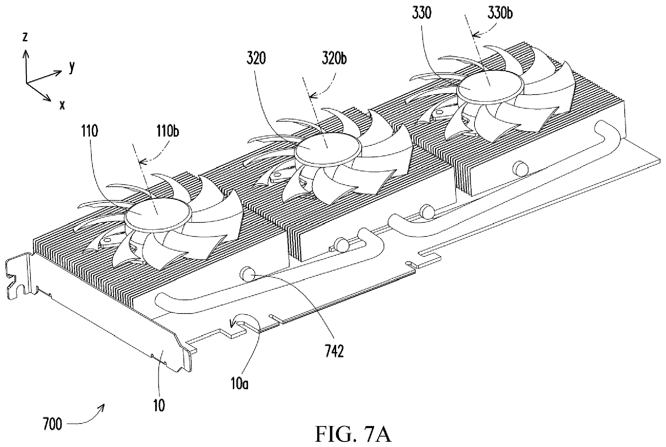

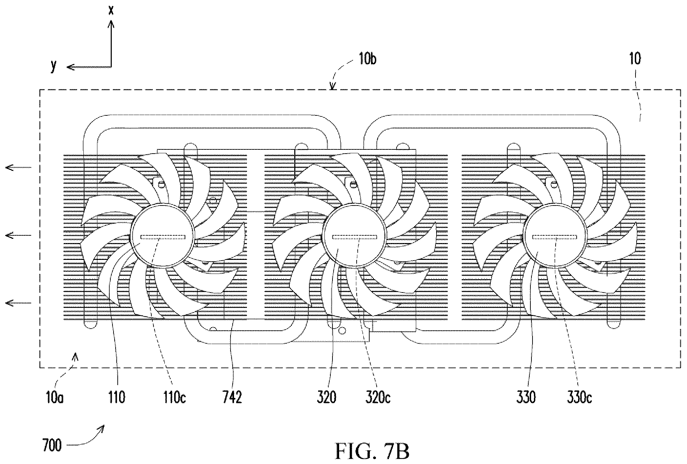

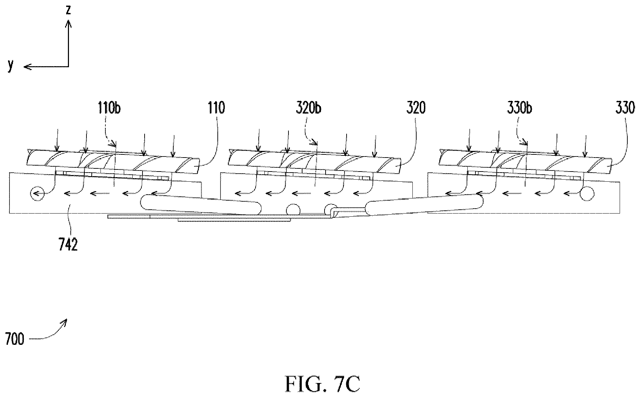

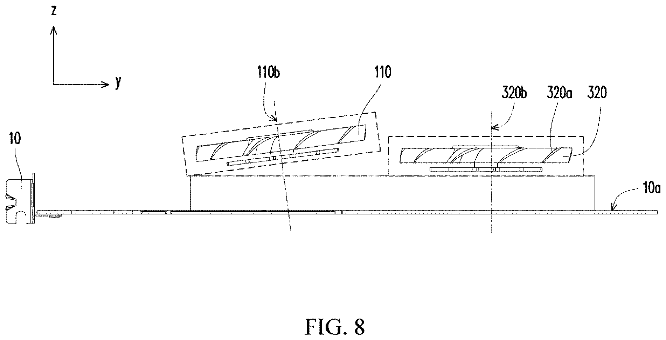

FIG. 7A is a diagram of a heat-dissipation device of an example of the present disclosure. FIG. 7B is a cross section diagram on xy plane of the heat-dissipation device in FIG. 7A. FIG. 7C is a cross section diagram on yz plane of the heat-dissipation device in FIG. 7A. Please refer to FIGs. 7A, 7B and 7C at the same time, in this example, the heat-dissipation device 700 is similar to the heat-dissipation device 600 of the previous example. Thus, only the differences are introduced here, and the same or similar units are used the same or similar reference signs to respect. In this example, the orthogonal projection 110c of the first rotating axis 110b on the surface 10a of the circuit board 10 is parallel to a long side 10b of the circuit board 10, and the first rotating axis 110b, the second rotating axis 320b and the third rotating axis 330b are parallel one another. In another word, the air flows of the first fan 110, the second fan 320 and the third fan 330 in this example are all flowed toward the same y-axis direction (the direction of the air flows are respected with the arrows in FIGs. 7B and 7C). The direction of the fins 742 are along the y-axis direction (as shown in FIG. 7B). Thus, the directions of the air flows and the fins 742 in heat-dissipation device 700 of the present example are opposed to those in the heat-dissipation device 600 of the previous example. FIG. 8 is a cross section diagram on yz plane of the heat-dissipation device in an example of the present disclosure. Please refer to FIG. 8, in the present example, the heat-dissipation device 800 is similar to the heat-dissipation device 100 shown in FIG. 1B, and only the differences are introduced here. In this example, the heat-dissipation device 800 further comprises a second fan 320. The blades of the second fan 320 rotate around the second rotating axis 320b, and the second rotating axis 320b is vertical to the surface 10a. In another word, the second rotating axis 320b of the second fan 320 and the first rotating axis 110b of the first fan 110 are not parallel in this example. The second fan 320 is disposed on the surface 10a of the circuit board 10 by a vertical-type, which is different to the first fan 110 disposed on the surface 10a of the circuit board 10 by a slope-type. Thus, the heat-dissipation device comprises multi-fans, and the rotating axes of those fans and the surface of the circuit board are forming an acute angle or a right angle.

On the basis of the above, the rotating axis of the fans and the surface of the circuit board are forming an acute angle in the heat-dissipation of the present invention. In other words, the fan is disposed on the surface of the circuit board by a slope-type. Therefore, the air flows of the fan will be flowed toward the same direction after encountering the surface of the circuit board for preventing the interference generated from the air flows causing the reduction of the cooling efficiency. Otherwise, because the rotating axis of the fan and the fins are parallel one another, the air flows will be passed through the passageways from those fins smoothly for dissipating heat quickly. In addition, the orthogonal projection of the rotating axis of the fan is parallel to the surface of the circuit board, and the directions of the rotating axis and the fins have the same direction. The air flows are flowed along the direction of the fins.

## Claims

1. A heat-dissipation device (100) for dissipating heat from a circuit board (10) and the circuit board (10) having a surface (10a), the heat-dissipation device (100) comprising:
a first fan (110), blades (110a) of said first fan (110) rotating around a first rotating axis (110b), and the first rotating axis (110b) and the surface (10a) forming an acute angle;
a second fan (320), blades (320a) of said second fan (320) rotating around a second rotating axis (320b), and the second rotating axis (320b) and the surface (10a) forming an acute angle; and
a third fan (330), blades (330a) of said third fan (330) rotating around a third rotating axis (330b), the third rotating axis (330b) and the surface (10a) forming an acute angle, and said second fan (320) being disposed between said first fan (110) and said third fan (330), wherein orthogonal projections (100c, 320c) of the second rotating axis (320b) and of the first rotating axis (110b) on the surface (10a) are perpendicular to one another, and the orthogonal projections (320c, 330c) of the second rotating axis (320b) and of the third rotating axis (330b) are perpendicular to one another; and the intersection between the first rotating axis (110b) and the circuit board (10) heading the direction away from said second fan (320), and the intersection between the third rotating axis (330b) and the circuit board (10) heading the direction away from said second fan (320);
the heat-dissipation device (100) further comprising a heat sink (340) disposed between said first fan (110), said second fan (320), said third fan (330) and the surface (10a) of the circuit board (10), said heat sink (340) including a plurality of first fins (342a) that are parallel in arrangement, a plurality of second fins (344a) that are parallel in arrangement and a plurality of third fins (346a) that are parallel in arrangement, the first fins (342a) being parallel to the orthogonal projection of the first rotating axis (110b), the second fins (344a) being parallel to the orthogonal projection of the second rotating axis (320b), and the third fins (346a) being parallel to the orthogonal projection of the third rotating axis (330b);
wherein air flows of said first fan (110) and said third fan (330) flow respectively through the passageways formed by the first fins (342a) and the third fins (346a) away from said second fan (320), and air flows of said second fan (320) flow through the passageways formed by the second fins (344a) away from said first fan (110) and said third fan (330).

2. A heat-dissipation device (300) as in claim 1, wherein the first fins (342a) are disposed between the surface (10a) of the circuit board (10) and said first fan (110), the second fins (344a) are disposed between the surface (10a) of the circuit board (10) and said second fan (320), and the third fins (346a) are disposed between the surface (10a) of the circuit board (10) and said third fan (330), wherein the first fins (342a), the second fins (344a) and the third fins (346a) are disposed vertically on the surface (10a).

3. A heat-dissipation device (300) as in claim 2, wherein laterals of the first fins (342a), the second fins (344a) and the third fins (346a) are formed in the shape of trapezium, and the first fins (342a) close to the edge of said first fan (110) being substantially vertical to the first rotating axis (110b), the second fins (344a) close to the edge of said second fan (320) being substantially vertical to the second rotating axis (320b), and the third fins (346a) close to the edge of said third fan (330) being substantially vertical to the third rotating axis (330b).

4. A heat-dissipation device (300) as in claim 2, further comprising at least a heat pipe (80) for passing through and connecting the first fins (342a), the second fins (344a) and the third fins (346a).

5. A heat-dissipation device (400) for dissipating heat from a circuit board (10) and the circuit board (10) having a surface (10a), the heat-dissipation device (400) comprising:
a first fan (110), blades (110a) of said first fan (110) rotating around a first rotating axis (110b), and the first rotating axis (110b) and the surface (10a) forming an acute angle;
a second fan (320), blades (320a) of said second fan (320) rotating around a second rotating axis (320b), and the second rotating axis (320b) and the surface (10a) forming an acute angle; and
a third fan (330), blades (330a) of said third fan (330) rotating around a third rotating axis (330b) and the third rotating axis (330b) and the surface (10a) forming an acute angle, and said second fan (320) disposed between said first fan (110) and said third fan (330), wherein orthogonal projections (110c, 320c) of the second rotating axis (320b) and of the first rotating axis (110b) on the surface (10a) are perpendicular one another, and the orthogonal projections (320c, 330c) of the second rotating axis (320b) and of the third rotating axis (330b) are parallel one another,
the heat-dissipation device (100) further comprising a heat sink (340) disposed between said first fan (110), said second fan (320), said third fan (330) and the surface (10a) of the circuit board (10), said heat sink (340) including a plurality of first fins (342a) that are parallel in arrangement, a plurality of second fins (344a) that are parallel in arrangement and a plurality of third fins (346a) that are parallel in arrangement, the first fins (342a) being parallel to the orthogonal projection of the first rotating axis (110b), the second fins (344a) being parallel to the orthogonal projection of the second rotating axis (320b), and the third fins (346a) being parallel to the orthogonal projection of the third rotating axis (330b);
wherein air flows of said first fan (110) and said third fan (330) flow respectively through the passageways formed by the first fins (342a) and the third fins (346a) away from said second fan (320), and air flows of said second fan (320) flow through the passageways formed by the second fins (344a) away from said first fan (110) and said third fan (330), wherein the circuit board (10) includes a long side (10b) and the orthogonal projection (110c) of the first rotating axis (110b) on the surface (10a) is parallel to the long side (10b) of the circuit board (10).

6. A heat-dissipation device (400, 500) as in claim 5, wherein the first fins (442, 542) are disposed between the surface (10a) of the circuit board (10) and said first fan (110), the second fins (444, 544) are disposed between the surface (10a) of the circuit board (10) and said second fan (320), and the third fins (446, 546) are disposed between the surface (10a) of the circuit board (10) and said third fan (330), wherein the first fins (442, 542), the second fins (444, 544) and third fins (446, 546) are disposed vertically on the surface (10a), the first fins (442, 542) being parallel to the first rotating axis (110b), the second fins (444, 544) being parallel to the second rotating axis (320b), and the third fins (446, 546) being parallel to the third rotating axis (330b).

7. A heat-dissipation device (400, 500) as in claim 6, wherein laterals of the first fins (442, 542), the second fins (444, 544) and the third fins (446, 546) are formed in the shape of trapezium, and the first fins (442, 542) close to the edge of said first fan (110) being substantially vertical to the first rotating axis (110b), the second fins (444, 544) close to the edge of said second fan (320) being substantially vertical to the second rotating axis (320b), and the third fins (446, 546) close to the edge of said third fan (330) being substantially vertical to the third rotating axis (330b).

8. A heat-dissipation device (400) as in claim 6, further comprising at least a first heat pipe (450) and at least a second heat pipe (460), wherein said first heat pipe (450) is connected with the first fins (442) and the second fins (444), and said second heat pipe (460) is passed through and connected with the second fins (444) and the third fins (446).

9. A heat-dissipation device (500) for dissipating heat from a circuit board (10) and the circuit board (10) having a surface (10a), the heat-dissipation device (400) comprising:
a first fan (110), blades (110a) of said first fan (110) rotating around a first rotating axis (110b), and the first rotating axis (110b) and the surface (10a) forming an acute angle;
a second fan (320), blades (320a) of said second fan (320) rotating around a second rotating axis (320b), and the second rotating axis (320b) and the surface (10a) forming an acute angle; and
a third fan (330), blades (330a) of said third fan (330) rotating around a third rotating axis (330b) and the third rotating axis (330b) and the surface (10a) forming an acute angle, and said second fan (320) disposed between said first fan (110) and said third fan (330), wherein orthogonal projections (110c, 320c) of the second rotating axis (320b) and of the first rotating axis (110b) on the surface (10a) are perpendicular one another, and the orthogonal projections (320c, 330c) of the second rotating axis (320b) and of the third rotating axis (330b) are collinear;
the heat-dissipation device (100) further comprising a heat sink (340) disposed between said first fan (110), said second fan (320), said third fan (330) and the surface (10a) of the circuit board (10), said heat sink (340) includes a plurality of first fins (342a) that are parallel in arrangement, a plurality of second fins (344a) that are parallel in arrangement and a plurality of third fins (346a) that are parallel in arrangement, the first fins (342a) being parallel to the orthogonal projection of the first rotating axis (110b), the second fins (344a) being parallel to the orthogonal projection of the second rotating axis (320b), and the third fins (346a) being parallel to the orthogonal projection of the third rotating axis (330b);
wherein air flows of said first fan (110) and said third fan (330) flow away from said second fan (320), and air flows of said second fan (320) flow away from said first fan (110) and toward said third fan (330), wherein the circuit board (10) includes a long side (10b) and the orthogonal projection (110c) of the first rotating axis (110b) on the surface (10a) is vertical to the long side (10b) of the circuit board (10).

## Patentansprüche

1. Wärmeableitungsgerät (100) zur Wärmeableitung von einer Leiterplatte (10), und wobei die Leiterplatte (10) eine Oberfläche (10a) aufweist, wobei das Wärmeableitungsgerät (100) umfasst:
einen ersten Ventilator (110), wobei Schaufeln (110a) des ersten Ventilators (110) um eine erste Rotationsachse (110b) rotieren, und wobei die erste Rotationsachse (110b) und die Oberfläche (10a) einen spitzen Winkel formen;
einen zweiten Ventilator (320), wobei Schaufeln (320a) des zweiten Ventilators (320) um eine zweite Rotationsachse (320b) rotieren, und wobei die zweite Rotationsachse (320b) und die Oberfläche (10a) einen spitzen Winkel formen; und
einen dritten Ventilator (330), wobei Schaufeln (330a) des dritten Ventilators (330) um eine dritte Rotationsachse (330b) rotieren, wobei die dritte Rotationsachse (330b) und die Oberfläche (10a) einen spitzen Winkel formen, und wobei der zweite Ventilator (320) zwischen dem ersten Ventilator (110) und dem dritten Ventilator (330) angeordnet ist,
wobei orthogonale Projektionen (100c, 320c) der zweiten Rotationsachse (320b) und der ersten Rotationsachse (110b) auf der Oberfläche (10a) senkrecht zueinander sind und wobei die orthogonalen Projektionen (320c, 330c) der zweiten Rotationsachse (320b) und der dritten Rotationsachse (330b) senkrecht zueinander sind; und wobei der Schnittpunkt zwischen der ersten Rotationsachse (110b) und der Leiterplatte (10) in Richtung von dem zweiten Ventilator (320) weg gerichtet ist, und wobei der Schnittpunkt zwischen der dritten Rotationsachse (330b) und der Leiterplatte (10) in Richtung von dem zweiten Ventilator (320) weg gerichtet ist;
wobei das Wärmeableitungsgerät (100) weiterhin umfasst
einen Wärmeableiter (340) angeordnet zwischen dem ersten Ventilator (110), dem zweiten Ventilator (320), dem dritten Ventilator (330) und der Oberfläche (10a) der Leiterplatte (10), wobei der Wärmeableiter (340) enthält eine Vielzahl von ersten Rippen (342a) in paralleler Anordnung, eine Vielzahl von zweiten Rippen (344a) in paralleler Anordnung und eine Vielzahl von dritten Rippen (346a) in paralleler Anordnung, wobei
die ersten Rippen (342a) parallel zu der orthogonalen Projektion der ersten Rotationsachse (110b) sind, die zweiten Rippen (344a) parallel zu der orthogonalen Projektion der zweiten Rotationsachse (320b) sind und wobei die dritten Rippen (346a) parallel zu der orthogonalen Projektion der dritten Rotationsachse (330b) sind;
wobei Luftströme des ersten Ventilators (110) und des dritten Ventilators (330) jeweilig durch Durchgänge strömen, welche von den ersten Rippen (342a) und den dritten Rippen (346a) geformt sind, weg von dem zweiten Ventilator (320), und wobei Luftströme des zweiten Ventilators (320) durch die Durchgänge strömen, welche von den zweiten Rippen (344a) geformt sind, weg von dem ersten Ventilator (110) und dem dritten Ventilator (330).

2. Wärmeableitungsgerät (300) gemäß Anspruch 1, wobei die ersten Rippen (342a) zwischen der Oberfläche (10a) der Leiterplatte (10) und dem ersten Ventilator (110) angeordnet sind, wobei die zweiten Rippen (344a) zwischen der Oberfläche (10a) der Leiterplatte (10) und dem zweiten Ventilator (320) angeordnet sind, und wobei die dritten Rippen (346a) zwischen der Oberfläche (10a) der Leiterplatte (10) und dem dritten Ventilator (330) angeordnet sind, wobei die ersten Rippen (342a), und die zweiten Rippen (344a) und die dritten Rippen (346a) vertikal auf der Oberfläche (10a) angeordnet sind.

3. Wärmeableitungsgerät (300) gemäß Anspruch 2, wobei Seitenteile der ersten Rippen (342a), der zweiten Rippen (344a) und der dritten Rippen (346a) in einer Trapezform geformt sind, und wobei die ersten Rippen (342a) nahe am Rande des ersten Ventilators (110) im Wesentlichen vertikal zu der ersten Rotationsachse (110b) sind, wobei die zweiten Rippen (344a) nahe am Rande des zweiten Ventilators (320) im Wesentlichen vertikal zu der zweiten Rotationsachse (320b) sind, und wobei die dritten Rippen (346a) nahe am Rande des dritten Ventilators (330) im Wesentlichen vertikal zu der dritten Rotationsachse (330b) sind.

4. Wärmeableitungsgerät (300) gemäß Anspruch 2, weiterhin mindestens eine Wärmeleitung (80) umfassend, um durchgeführt zu sein durch und verbunden zu sein mit den ersten Rippen (342a), den zweiten Rippen (344a) und den dritten Rippen (346a).

5. Wärmeableitungsgerät (400) zur Wärmeableitung von einer Leiterplatte (10), wobei die Leiterplatte (10) eine Oberfläche (10a) aufweist, wobei das Wärmeableitungsgerät (400), umfasst:
einen ersten Ventilator (110), wobei Schaufeln (110a) des ersten Ventilators (110) um eine erste Rotationsachse (110b) rotieren, und wobei die erste Rotationsachse (110b) und die Oberfläche (10a) einen spitzen Winkel formen;
einen zweiten Ventilator (320), wobei Schaufeln (320a) des zweiten Ventilators (320) um eine zweite Rotationsachse (320b) rotieren, und wobei die zweite Rotationsachse (320b) und die Oberfläche (10a) einen spitzen Winkel formen; und
einen dritten Ventilator (330), wobei Schaufeln (330a) des dritten Ventilators (330) um eine dritte Rotationsachse (330b) rotieren, wobei die dritte Rotationsachse (330b) und die Oberfläche (10a) einen spitzen Winkel formen, und wobei der zweite Ventilator (320) zwischen dem ersten Ventilator (110) und dem dritten Ventilator (330) angeordnet ist,
wobei orthogonale Projektionen (100c, 320c) der zweiten Rotationsachse (320b) und der ersten Rotationsachse (110b) auf der Oberfläche (10a) senkrecht zueinander sind und wobei die orthogonalen Projektionen (320c, 330c) der zweiten Rotationsachse (320b) und der dritten Rotationsachse (330b) parallel zueinander sind, wobei das Wärmeableitungsgerät (100) weiterhin umfasst
einen Wärmeableiter (340), angeordnet zwischen dem ersten Ventilator (110), dem zweiten Ventilator (320), dem dritten Ventilator (330) und der Oberfläche (10a) der Leiterplatte (10), wobei der Wärmeableiter (340) enthält eine Vielzahl von ersten Rippen (342a) in paralleler Anordnung, eine Vielzahl von zweiten Rippen (344a) in paralleler Anordnung und eine Vielzahl von dritten Rippen (346a) in paralleler Anordnung, wobei
die ersten Rippen (342a) parallel zu der orthogonalen Projektion der ersten Rotationsachse (1 10b) sind, die zweiten Rippen (344a) parallel zu der orthogonalen Projektion der zweiten Rotationsachse (320b) sind und wobei die dritten Rippen (346a) parallel zu der orthogonalen Projektion der dritten Rotationsachse (330b) sind;
wobei Luftströme des ersten Ventilators (110) und des dritten Ventilators (330) jeweilig durch Durchgänge strömen, welche von den ersten Rippen (342a) und den dritten Rippen (346a) geformt sind, weg von dem zweiten Ventilator (320), und wobei Luftströme des zweiten Ventilators (320) durch die Durchgänge strömen, welche von den zweiten Rippen (344a) geformt sind, weg von dem ersten Ventilator (110) und dem dritten Ventilator (330), wobei die Leiterplatte (10) eine lange Seite (10b) enthält und wobei die orthogonale Projektion (110c) der ersten Rotationsachse (110b) auf der Oberfläche (10a) parallel zu der langen Seite (10b) der Leiterplatte (10) ist.

6. Wärmeableitungsgerät (400, 500) gemäß Anspruch 5, wobei die ersten Rippen (442, 542) zwischen der Oberfläche (10a) der Leiterplatte (10) und dem ersten Ventilator (110) angeordnet sind, die zweiten Rippen (444, 544) zwischen der Oberfläche (10a) der Leiterplatte (10) und dem zweiten Ventilator (320) angeordnet sind, und wobei die dritten Rippen (446, 546) zwischen der Oberfläche (10a) der Leiterplatte (10) und dem dritten Ventilator (330) angeordnet sind, wobei
die ersten Rippen (442, 542), die zweiten Rippen (444,544) und die dritten Rippen (446, 546) vertikal auf der Oberfläche (10a) angeordnet sind, die ersten Rippen (442, 542) parallel zu der ersten Rotationsachse (110b) angeordnet sind, die zweiten Rippen (444, 544) parallel zu der zweiten Rotationsachse (320b) angeordnet sind, und wobei die dritten Rippen (446, 546) parallel zu der dritten Rotationsachse (330b) angeordnet sind.

7. Wärmeableitungsgerät (400, 500) gemäß Anspruch 6, wobei Seitenteile der ersten Rippen (442, 542), der zweiten Rippen (444, 544) und der dritten Rippen (446, 546) in einer Trapezform geformt sind, und wobei die ersten Rippen (442, 542) nahe am Rande des ersten Ventilator (110) im Wesentlichen vertikal zu der ersten Rotationsachse (110b) sind, die zweiten Rippen (444, 544) nahe am Rande des zweiten Ventilators (320) im Wesentlichen vertikal zu der zweiten Rotationsachse (320b) sind, und wobei die dritten Rippen (446, 546) nahe am Rande des dritten Ventilators (330) im Wesentlichen vertikal zu der dritten Rotationsachse (330b) sind.

8. Wärmeableitungsgerät (400) gemäß Anspruch 6, weiterhin mindestens eine erste Wärmeleitung (450) und eine zweite Wärmeleitung (460) umfassend, wobei die erste Wärmeleitung (450) mit den ersten Rippen (442) und die zweiten Rippen (444) verbunden ist, und wobei die zweite Wärmeleitung (460) durch die zweiten Rippen (444) und die dritten Rippen (446) durchgeführt und mit diesen verbunden ist.

9. Wärmeableitungsgerät (500) zur Wärmeableitung von einer Leiterplatte (10), und wobei die Leiterplatte (10) eine Oberfläche (10a) aufweist, wobei das Wärmeableitungsgerät (400) umfasst:
einen ersten Ventilator (110), wobei Schaufeln (110a) des ersten Ventilators (110) um eine erste Rotationsachse (110b) rotieren, und wobei die erste Rotationsachse (110b) und die Oberfläche (10a) einen spitzen Winkel formen;
einen zweiten Ventilator (320), wobei Schaufeln (320a) des zweiten Ventilators (320) um eine zweite Rotationsachse (320b) rotieren, und wobei die zweite Rotationsachse (320b) und die Oberfläche (10a) einen spitzen Winkel formen; und
einen dritten Ventilator (330), wobei Schaufeln (330a) des dritten Ventilators (330) um eine dritte Rotationsachse (330b) rotieren, wobei die dritte Rotationsachse (330b) und die Oberfläche (10a) einen spitzen Winkel formen, und wobei der zweite Ventilator (320) zwischen dem ersten Ventilator (110) und dem dritten Ventilator (330) angeordnet ist,
wobei orthogonale Projektionen (100c, 320c) der zweiten Rotationsachse (320b) und der ersten Rotationsachse (110b) auf der Oberfläche (10a) senkrecht zueinander sind und wobei die orthogonalen Projektionen (320c, 330c) der zweiten Rotationsachse (320b) und der dritten Rotationsachse (330b) kollinear zueinander sind; wobei das Wärmeableitungsgerät (100) weiterhin umfasst
einen Wärmeableiter (340) angeordnet zwischen dem ersten Ventilator (110), dem zweiten Ventilator (320), dem dritten Ventilator (330) und der Oberfläche (10a) der Leiterplatte (10), wobei der Wärmeableiter (340) enthält eine Vielzahl von ersten Rippen (342a) in paralleler Anordnung, eine Vielzahl von zweiten Rippen (344a) in paralleler Anordnung und eine Vielzahl von dritten Rippen (346a) in paralleler Anordnung, wobei
die ersten Rippen (342a) parallel zu der orthogonalen Projektion der ersten Rotationsachse (110b) sind, die zweiten Rippen (344a) parallel zu der orthogonalen Projektion der zweiten Rotationsachse (320b) sind und wobei die dritten Rippen (346a) parallel zu der orthogonalen Projektion der dritten Rotationsachse (330b) sind;
wobei Luftströme des ersten Ventilators (110) und des dritten Ventilators (330) weg von dem zweiten Ventilator (320) strömen, und wobei Luftströme des zweiten Ventilators (320) weg von dem ersten Ventilator (110) und zu dem dritten Ventilator (330) hin strömen, wobei die Leiterplatte (10) eine lange Seite (10b) enthält und wobei die orthogonale Projektion (110c) der ersten Rotationsachse (110b) auf der Oberfläche (10a) vertikal zu der langen Seite (10b) der Leiterplatte (10) ist.

## Revendications

1. Dispositif de dissipation thermique (100) pour dissiper la chaleur d'une carte de circuit (10) et la carte de circuit (10) comportant une surface (10a), le dispositif de dissipation thermique (100) comprenant :
- un premier ventilateur (110), des pales (110a) dudit premier ventilateur (110) tournant autour d'un premier axe de rotation (110b), et le premier axe de rotation (110b) et la surface (10a) formant un angle aigu ;
- un deuxième ventilateur (320), des pales (320a) dudit deuxième ventilateur (320) tournant autour d'un deuxième axe de rotation (320b), et le deuxième axe de rotation (320b) et la surface (10a) formant un angle aigu, et
- un troisième ventilateur (330), des pales (330a) dudit troisième ventilateur (330) tournant autour d'un troisième axe de rotation (330b), le troisième axe de rotation (330b) et la surface (10a) formant un angle aigu, et ledit deuxième ventilateur (320) étant disposé entre ledit premier ventilateur (110) et ledit troisième ventilateur (330),
dans lequel des saillies orthogonales (100c, 320c) du deuxième axe de rotation (320b) et du premier axe de rotation (110b) sur la surface (10a) sont perpendiculaires les unes aux autres, et les saillies orthogonales (320c, 330c) du deuxième axe de rotation (320b) et du troisième axe de rotation (330b) sont perpendiculaires les unes aux autres ; et l'intersection entre le premier axe de rotation (110b) et la carte de circuit (10) allant dans la direction opposée par rapport audit deuxième ventilateur (320), et l'intersection entre le troisième axe de rotation (330b) et la carte de circuit (10) allant dans la direction opposée par rapport audit deuxième ventilateur (320) ;
- le dispositif de dissipation thermique (100) comprenant en outre un dissipateur thermique (340) disposé entre ledit premier ventilateur (110), ledit deuxième ventilateur (320), ledit troisième ventilateur (330) et la surface (10a) de la carte de circuit (10), ledit dissipateur thermique (340) comprenant une pluralité de premières ailettes (342a) arrangées de façon parallèle, une pluralité de deuxièmes ailettes (344a) arrangées de façon parallèle et une pluralité de troisièmes ailettes (346a) arrangées de façon parallèle,
- les premières ailettes (342a) étant parallèles à la saillie orthogonale du premier axe de rotation (110b), les deuxièmes ailettes (344a) étant parallèles à la saillie orthogonale du deuxième axe de rotation (320b), et les troisièmes ailettes (346a) étant parallèles à la saillie orthogonale du troisième axe de rotation (330b) ; dans lequel des flux d'air dudit premier ventilateur (110) et dudit troisième ventilateur (330) s'écoulent respectivement à travers les passages formés par les premières ailettes (342a) et les troisièmes ailettes (346a) à distance dudit deuxième ventilateur (320), et des flux d'air dudit deuxième ventilateur (320) s'écoulent à travers les passages formés par les deuxièmes ailettes (344a) à distance dudit premier ventilateur (110) et dudit troisième ventilateur (330).

2. Dispositif de dissipation thermique (300) selon la revendication 1, dans lequel les premières ailettes (342a) sont disposées entre la surface (10a) de la carte de circuit (10) et ledit premier ventilateur (110), les deuxièmes ailettes (344a) sont disposées entre la surface (10a) de la carte de circuit (10) et ledit deuxième ventilateur (320), et les troisièmes ailettes (346a) sont disposées entre la surface (10a) de la carte de circuit (10) et ledit troisième ventilateur (330), dans lequel les premières ailettes (342a), les deuxièmes ailettes (344a) et les troisièmes ailettes (346a) sont disposées verticalement sur la surface (10a).

3. Dispositif de dissipation thermique (300) selon la revendication 2, dans lequel des parties latérales des premières ailettes (342a), des deuxièmes ailettes (344a) et des troisièmes ailettes (346a) présentent une forme de trapèze, et les premières ailettes (342a) proches du bord dudit premier ventilateur (110) sont substantiellement verticales par rapport au premier axe de rotation (110b), les deuxièmes ailettes (344a) proches du bord dudit deuxième ventilateur (320) sont substantiellement verticales par rapport au deuxième axe de rotation (320b), et les troisièmes ailettes (346a) proches du bord dudit troisième ventilateur (330) sont substantiellement verticales par rapport au troisième axe de rotation (330b).

4. Dispositif de dissipation thermique (300) selon la revendication 2, comprenant en outre au moins un conduit thermique (80) destiné à passer à travers les premières ailettes (342a), les deuxièmes ailettes (344a) et les troisièmes ailettes (346a) tout en reliant celles-ci.

5. Dispositif de dissipation thermique (400) pour la dissipation de la chaleur d'une carte de circuit (10) et la carte de circuit (10) comportant une surface (10a), le dispositif de dissipation thermique (400) comprenant :
- un premier ventilateur (110), des pales (110a) dudit premier ventilateur (110) tournant autour d'un premier axe de rotation (110b), et le premier axe de rotation (110b) et la surface (10a) formant un angle aigu ;
- un deuxième ventilateur (320), des pales (320a) dudit deuxième ventilateur (320) tournant autour d'un deuxième axe de rotation (320b), et le deuxième axe de rotation (320b) et la surface (10a) formant un angle aigu, et
- un troisième ventilateur (330), des pales (330a) dudit troisième ventilateur (330) tournant autour d'un troisième axe de rotation (330b), le troisième axe de rotation (330b) et la surface (10a) formant un angle aigu, et ledit deuxième ventilateur (320) étant disposé entre ledit premier ventilateur (110) et ledit troisième ventilateur (330),
dans lequel des saillies orthogonales (100c, 320c) du deuxième axe de rotation (320b) et du premier axe de rotation (110b) sur la surface (10a) sont perpendiculaires les unes aux autres, et les saillies orthogonales (320c, 330c) du deuxième axe de rotation (320b) et du troisième axe de rotation (330b) sont perpendiculaires les unes aux autres ;
- le dispositif de dissipation thermique (100) comprenant en outre un dissipateur thermique (340) disposé entre ledit premier ventilateur (110), ledit deuxième ventilateur (320), ledit troisième ventilateur (330) et la surface (10a) de la carte de circuit (10), ledit dissipateur thermique (340) comprenant une pluralité de premières ailettes (342a) arrangées de façon parallèle, une pluralité de deuxièmes ailettes (344a) arrangées de façon parallèle et une pluralité de troisièmes ailettes (346a) arrangées de façon parallèle, les premières ailettes (342a) étant parallèles à la saillie orthogonale du premier axe de rotation (110b), les deuxièmes ailettes (344a) étant parallèles à la saillie orthogonale du deuxième axe de rotation (320b), et les troisièmes ailettes (346a) étant parallèles à la saillie orthogonale du troisième axe de rotation (330b) ;
dans lequel des flux d'air dudit premier ventilateur (110) et dudit troisième ventilateur (330) s'écoulent respectivement à travers les passages formés par les premières ailettes (342a) et les troisièmes ailettes (346a) à distance dudit deuxième ventilateur (320), et des flux d'air dudit deuxième ventilateur (320) s'écoulent à travers les passages formés par les deuxièmes ailettes (344a) à distance dudit premier ventilateur (110) et dudit troisième ventilateur (330), la carte de circuit (10) comprenant un côté long (10b) et la saillie orthogonale (110c) du premier axe de rotation (110b) sur la surface (10a) étant parallèle au côté long (10b) de la carte de circuit (10).

6. Dispositif de dissipation thermique (400, 500) selon la revendication 5, dans lequel les premières ailettes (442, 542) sont disposées entre la surface (10a) de la carte de circuit (10) et ledit premier ventilateur (110), les deuxièmes ailettes (444, 544) sont disposées entre la surface (10a) de la carte de circuit (10) et ledit deuxième ventilateur (320), et les troisièmes ailettes (446, 546) sont disposées entre la surface (10a) de la carte de circuit (10) et ledit troisième ventilateur (330), dans lequel les premières ailettes (442, 542), les deuxièmes ailettes (444, 544) et les troisièmes ailettes (446, 546) sont disposées verticalement sur la surface (10a), les premières ailettes (442, 542) étant parallèles au premier axe de rotation (110b), les deuxièmes ailettes (444, 544) étant parallèles au deuxième axe de rotation (320b), et les troisièmes ailettes (446, 546) étant parallèles au troisième axe de rotation (330b).

7. Dispositif de dissipation thermique (400, 500) selon la revendication 6, dans lequel des parties latérales des premières ailettes (442, 542), des deuxièmes ailettes (444, 544) et des troisièmes ailettes (446, 546) présentent une forme de trapèze, et les premières ailettes (442, 542) proches du bord dudit premier ventilateur (110) sont substantiellement verticales par rapport au premier axe de rotation (110b), les deuxièmes ailettes (444 ; 544) proches du bord dudit deuxième ventilateur (320) sont substantiellement verticales par rapport au deuxième axe de rotation (320b), et les troisièmes ailettes (446, 546) proches du bord dudit troisième ventilateur (330) sont substantiellement verticales par rapport au troisième axe de rotation (330b).

8. Dispositif de dissipation thermique (400) selon la revendication 6, comprenant en outre au moins un premier conduit thermique (450) et au moins un deuxième conduit thermique (460), dans lequel ledit premier conduit thermique (450) est relié aux premières ailettes (442) et aux deuxièmes ailettes (444), et ledit deuxième conduit thermique (460) passe à travers les deuxièmes ailettes (444) et les troisièmes ailettes (446) tout en étant relié à celles-ci.

9. Dispositif de dissipation thermique (500) pour la dissipation de la chaleur d'une carte de circuit (10) et la carte de circuit (10) comportant une surface (10a), le dispositif de dissipation thermique (400) comprenant :
- un premier ventilateur (110), des pales (110a) dudit premier ventilateur (110) tournant autour d'un premier axe de rotation (110b), et le premier axe de rotation (110b) et la surface (10a) formant un angle aigu ;
- un deuxième ventilateur (320), des pales (320a) dudit deuxième ventilateur (320) tournant autour d'un deuxième axe de rotation (320b), et le deuxième axe de rotation (320b) et la surface (10a) formant un angle aigu, et
- un troisième ventilateur (330), des pales (330a) dudit troisième ventilateur (330) tournant autour d'un troisième axe de rotation (330b), le troisième axe de rotation (330b) et la surface (10a) formant un angle aigu, et ledit deuxième ventilateur (320) étant disposé entre ledit premier ventilateur (110) et ledit troisième ventilateur (330),
dans lequel des saillies orthogonales (100c, 320c) du deuxième axe de rotation (320b) et du premier axe de rotation (110b) sur la surface (10a) sont perpendiculaires les unes aux autres, et les saillies orthogonales (320c, 330c) du deuxième axe de rotation (320b) et du troisième axe de rotation (330b) sont colinéaires ;
- le dispositif de dissipation thermique (100) comprenant en outre un dissipateur thermique (340) disposé entre ledit premier ventilateur (110), ledit deuxième ventilateur (320), ledit troisième ventilateur (330) et la surface (10a) de la carte de circuit (10), ledit dissipateur thermique (340) comprenant une pluralité de premières ailettes (342a) arrangées de façon parallèle, une pluralité de deuxièmes ailettes (344a) arrangées de façon parallèle et une pluralité de troisièmes ailettes (346a) arrangées de façon parallèle, les premières ailettes (342a) étant parallèles à la saillie orthogonale du premier axe de rotation (110b), les deuxièmes ailettes (344a) étant parallèles à la saillie orthogonale du deuxième axe de rotation (320b), et les troisièmes ailettes (346a) étant parallèles à la saillie orthogonale du troisième axe de rotation (330b) ;
dans lequel des flux d'air dudit premier ventilateur (110) et dudit troisième ventilateur (330) s'écoulent à distance dudit deuxième ventilateur (320), et des flux d'air dudit deuxième ventilateur (320) s'écoulent à distance dudit premier ventilateur (110) et vers troisième ventilateur (330), la carte de circuit (10) comprenant un côté long (10b) et la saillie orthogonale (110c) du premier axe de rotation (110b) sur la surface (10a) étant verticale par rapport au côté long (10b) de la carte de circuit (10) .
